(19) Europäisches Patentamt
European Patent Office
Office européen des brevets

(11) **EP 4 070 353 B1**

(12) **EUROPÄISCHE PATENTSCHRIFT**

(45) Veröffentlichungstag und Bekanntmachung des Hinweises auf die Patenterteilung:
**15.11.2023  Patentblatt 2023/46**

(21) Anmeldenummer: **20824137.2**

(22) Anmeldetag: **03.12.2020**

(51) Internationale Patentklassifikation (IPC):
***H01H 47/00*** *(2006.01)*

(52) Gemeinsame Patentklassifikation (CPC):
**H01H 47/002;** H01H 9/16

(86) Internationale Anmeldenummer:
**PCT/EP2020/084485**

(87) Internationale Veröffentlichungsnummer:
**WO 2021/110844 (10.06.2021 Gazette 2021/23)**

(54) **ERFASSEN EINES SCHALTZUSTANDS EINES ELEKTROMECHANISCHEN SCHALTELEMENTS**

SENSING A SWITCHING STATE OF AN ELECTROMECHANICAL SWITCHING ELEMENT

DÉTECTION D'ÉTAT DE COMMUTATION D'ÉLÉMENT DE COMMUTATION ÉLECTROMÉCANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.12.2019  DE 102019218919**

(43) Veröffentlichungstag der Anmeldung:
**12.10.2022  Patentblatt 2022/41**

(73) Patentinhaber: **Siemens Schweiz AG**
**8047 Zürich (CH)**

(72) Erfinder: **TREMMEL, Maximilian**
**93055 Regensburg (DE)**

(74) Vertreter: **Siemens Patent Attorneys**
**Postfach 22 16 34**
**80506 München (DE)**

(56) Entgegenhaltungen:
**DE-A1-102006 054 877     DE-B3-102014 111 335**
**DE-C1- 10 146 753**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Sensoreinrichtung zum Ermitteln eines Schaltzustands eines elektromechanischen Schaltelements, mit wenigstens zwei Anschlusselementen zum elektrischen Kontaktieren von zwei jeweiligen Anschlusskontakten des elektromechanischen Schaltelements. Die Erfindung betrifft ferner ein Verfahren zum Ermitteln eines Schaltzustands eines elektromechanischen Schaltelements.

Sensoreinrichtungen sowie auch Verfahren der gattungsgemäßen Art finden insbesondere Einsatz bei der Gebäudeautomation sowie auch bei der analogen Schaltungstechnik, beispielsweise beim Ermitteln eines Schaltzustands eines elektromechanischen Schaltelements, beispielsweise eines manuell betätigbaren elektromechanischen Schalters, eines manuell betätigbaren elektromechanischen Tasters und/oder dergleichen. Derartige elektromechanische Schaltelemente werden in der Regel potentialfrei betrieben, das heißt, sie sind mit ihren wenigstens zwei Anschlüssen mit der Sensoreinrichtung elektrisch gekoppelt. Dabei ist zu beachten, dass die Schaltelemente mit einer beliebigen Betriebsspannung, auch Fremdspannung genannt, beaufschlagt sein können, beispielsweise einer Netzspannung von 230 V bei einer Frequenz von etwa 50 Hz oder dergleichen.

Um den Schaltzustand des elektromechanischen Schaltelements erfassen zu können, ist es in der Regel erforderlich, dass das Schaltelement mit einer elektrischen Spannung beaufschlagt und ein Stromfluss durch das Schaltelement erfasst wird. Befindet sich das Schaltelement im ausgeschalteten Schaltzustand beträgt der erfasste Strom im Wesentlichen null. Befindet sich das Schaltelement hingegen im eingeschalteten Schaltzustand, ist ein signifikanter elektrischer Strom erfassbar, der es erlaubt, auf eine niederohmige Schleifenimpedanz und somit auf den eingeschalteten Schaltzustand des Schaltelements schließen zu können. Ist trotz angelegter elektrischer Spannung im Wesentlichen kein Strom erfassbar, so kann daraus geschlossen werden, dass das Schaltelement im ausgeschalteten Schaltzustand ist.

Derartige elektrische Installationen, insbesondere im Bereich der Gebäudetechnik beziehungsweise -automation werden unter Nutzung eines Feld-BUSses realisiert, beispielsweise gemäß einem KNX-Standard oder dergleichen. Der KNX-Standard ist ein Feld-BUS zur Gebäudeautomation. Dieser Standard ist ein Nachfolger der Feld-BUSse Europäischer Installationsbus (EIB), Bati-BUS sowie auch European Home Systems (EHS). Hinsichtlich der Technologie ist der KNX-Standard eine Weiterentwicklung des EIB, insbesondere durch Erweiterung um Konfigurationsmechanismen sowie Übertragungsmedien, die ursprünglich bereits auch für den Bati-BUS und EHS entwickelt worden waren.

DE 101 46 753 C1 offenbart eine Sensoreinrichtung gemäß dem Oberbegriff des Anspruchs 1.

Auch wenn sich diese Konzepte bewährt haben, so verbleiben dennoch Probleme. Als störend erweist es sich insbesondere, dass während der Montage das Problem auftreten kann, dass die Anschlusselemente der Sensoreinrichtung nicht mit potentialfreien elektromechanischen Schaltelementen verbunden werden, sondern stattdessen versehentlich mit potentialbehafteten elektromechanischen Schaltelementen. Bei einer Inbetriebnahme kann dann die Sensoreinrichtung mit einer hohen elektrischen Spannung beaufschlagt werden, die dazu führen kann, dass die Sensoreinrichtung zumindest beschädigt wird. Gerade bei komplexen Gebäudeinstallationen ist dies besonders nachteilig.

Der Erfindung liegt die Aufgabe zugrunde, eine gattungsgemäße Sensoreinrichtung sowie auch ein gattungsgemäßes Verfahren dahingehend zu verbessern, dass eine Beschädigung der Sensoreinrichtung bei einem fehlerhaften Anschluss reduziert oder sogar gänzlich vermieden werden kann.

Als Lösung werden mit der Erfindung eine Sensoreinrichtung sowie ein Verfahren gemäß den unabhängigen Ansprüchen vorgeschlagen.

Vorteilhafte Weiterbildungen ergeben sich durch Merkmale der abhängigen Ansprüche.

Bezüglich einer gattungsgemäßen Sensoreinrichtung wird mit der Erfindung insbesondere vorgeschlagen, dass die Sensoreinrichtung wenigstens einen Koppelkondensator mit einem ersten und einem zweiten Kondensatoranschluss aufweist, wobei der erste Kondensatoranschluss mit einem ersten der Anschlusselemente elektrisch gekoppelt ist, wobei die Sensoreinrichtung ferner einen Spannungsgenerator zum Bereitstellen einer zeitlich veränderlichen elektrischen Spannung aufweist, wobei der Spannungsgenerator mit dem zweiten Kondensatoranschluss elektrisch gekoppelt ist, wobei die Sensoreinrichtung ferner eine mit einem zweiten der Anschlusselemente elektrisch gekoppelte erste Überspannungsschutzschaltung aufweist, die ausgebildet ist, eine elektrische Spannung, deren Betrag größer als ein maximaler Betrag der zeitlich veränderlichen elektrischen Spannung des Spannungsgenerators ist, zu blockieren, sowie dass die Sensoreinrichtung eine mit der ersten Überspannungsschutzschaltung elektrisch gekoppelte Detektorschaltung aufweist, die ausgebildet ist, die elektrische Spannung zu erfassen und durch Auswerten der erfassten elektrischen Spannung den Schaltzustand des elektromechanischen Schaltelements zu ermitteln.

In Bezug auf ein gattungsgemäßes Verfahren wird mit der Erfindung insbesondere vorgeschlagen, dass das Verfahren die Schritte aufweist:

- Bereitstellen einer zeitlich veränderlichen elektrischen Spannung mittels eines Spannungsgenerators,
- Beaufschlagen eines ersten Anschlusskontaktes des elektromechanischen Schaltelements mit der zeitlich veränderlichen elektrischen Spannung über wenigstens einen Koppelkondensator,

- Erfassen einer elektrischen Spannung eines zweiten Anschlusskontaktes des elektromechanischen Schaltelements mittels einer Detektorschaltung über eine erste Überspannungsschutzschaltung, die ausgebildet ist, eine elektrische Spannung, deren Betrag größer als ein maximaler Betrag der zeitlich veränderlichen elektrischen Spannung des Spannungsgenerators ist, zu blockieren, und
- Ermitteln des Schaltzustands des elektromechanischen Schaltelements mittels der Detektorschaltung durch Auswerten der erfassten elektrischen Spannung.

Es ist ein Gedanke der Erfindung, einen zusätzlichen Schutz gegenüber einem falschen Anschluss der Sensoreinrichtung an elektromechanische Schaltelemente zu erreichen, indem nämlich einerseits mit dem Koppelkondensator erreicht werden kann, dass die Sensoreinrichtung vor einer Einwirkung aufgrund eines großen elektrischen Potentials am ersten der Anschlusselemente beziehungsweise Anschlusskontakte geschützt werden kann, und zugleich die erste Überspannungsschutzschaltung die Detektorschaltung schützen kann, die mit dem zweiten der Anschlusselemente beziehungsweise Anschlusskontakte elektrisch gekoppelt ist. Dadurch kann auch durch Anschluss der Sensoreinrichtung an ein elektromechanisches Schaltelement, welches keine potentialfreien Anschlusskontakte aufweist, ein wirksamer Schutz der Sensoreinrichtung vor Beschädigung aufgrund eines unzulässigen elektrischen Potentials erreicht werden. Insgesamt ermöglicht es die Erfindung daher, die Nutzung der Sensoreinrichtung nicht nur aber besonders bei der Gebäudeautomation, insbesondere in Bezug auf eine Erstellung einer Gebäudeinstallation, ein Ändern der Gebäudeinstallation und/oder des Weiteren zu verbessern. Ein fehlerhafter Anschluss der Sensoreinrichtung an ein nicht vorgesehenes elektromechanisches Schaltelement braucht somit nicht mehr zu einer Beschädigung beziehungsweise zu einer Zerstörung der Sensoreinrichtung zu führen. Dadurch kann insbesondere in Bezug auf komplexe Gebäudeinstallationen eine erhebliche Verbesserung der Zuverlässigkeit erreicht werden. Die Suche nach fehlerhaften Sensoreinrichtungen kann dadurch weitgehend eingespart werden.

Die Erfindung eignet sich dabei besonders in Verbindung mit der Nutzung von Feld-BUSsen, an denen die Sensoreinrichtung angeschlossen sein kann. Durch die Erfindung kann nämlich erreicht werden, dass eine Rückwirkung auf den entsprechenden Feld-BUS durch die Sensoreinrichtung gemäß der Erfindung weitgehend vermieden werden kann. Die Sensoreinrichtung als solche ist daher nicht nur gegenüber dem Stand der Technik besser geschützt, sondern sie führt darüber hinaus auch zu einem verbesserten Schutz eines an die Sensoreinrichtung angeschlossenen Feld-BUSses.

Durch die Erfindung kann zum Beispiel in Bezug auf eine KNX-Gebäudetechnik ein universelles Gerät bereitgestellt werden, welches sowohl Spannungen als auch geschlossene Stromkreise detektieren kann. Insbesondere kann erreicht werden, dass die Detektorschaltung in Bezug auf eine gängige Betriebsspannung bei Gebäuden, beispielsweise etwa 230 V bei etwa 50 Hz tolerant ist und vorzugsweise bei einer derartigen Beaufschlagung im Wesentlichen schadfrei bleiben kann. Zugleich kann mit der Erfindung erreicht werden, dass es bei einer entsprechenden Spannungsbeaufschlagung zu keinem entsprechend großen Stromfluss und im Wesentlichen auch zu keinem gefährlichen Zustand kommen kann.

Das elektromechanische Schaltelement kann beispielsweise ein manuell betätigbarer Schalter, ein manuell betätigbarer Taster, ein manuell betätigbarer Schalter mit einer Umschaltfunktion, zusätzlichen Kontaktpaaren für zusätzliche Funktionalitäten und/oder dergleichen sein. Dem Grunde nach kann das elektromechanische Schaltelement natürlich auch ein Drehschalter, insbesondere ein manuell betätigbarer Drehschalter sein. Das Schaltelement braucht jedoch nicht nur manuell betätigbar zu sein. Natürlich kann das elektromechanische Schaltelement auch mittels einer geeigneten Antriebseinrichtung betätigbar sein, beispielsweise bei einem Schütz, einem Relais, Kombinationsschaltungen und/oder dergleichen.

Das elektromechanische Schaltelement umfasst wenigstens zwei jeweilige Anschlusskontakte an denen das elektromechanische Schaltelement mit der Sensoreinrichtung elektrisch gekoppelt werden kann. Vorzugsweise ist jeder der Anschlusskontakte mit einem entsprechenden Kontaktelement des elektromechanischen Schaltelements verbunden, sodass zwischen den wenigstens zwei Anschlusskontakten die jeweilige Schaltfunktion bereitgestellt werden kann. So zeichnet sich beispielsweise der ausgeschaltete Schaltzustand bei einem elektromechanischen Schaltelement mit zwei Anschlusskontakten dadurch in der Regel aus, dass zwischen diesen beiden Anschlusskontakten keine elektrische Verbindung besteht, weil die entsprechenden Kontaktelemente im ausgeschalteten Schaltzustand beabstandet voneinander positioniert sind. Im eingeschalteten Schaltzustand hingegen kontaktieren sich die Kontaktelemente, sodass zwischen den Anschlusskontakten eine niederohmige elektrische Verbindung vorliegt. Vorzugsweise bezieht sich der Zustand auf ein jeweiliges Paar von zugeordneten Anschlusskontakten mit den jeweiligen Kontaktelementen.

Der Koppelkondensator ist ein elektronisches Bauteil, welches eine elektrische Kapazität bereitstellt. Die Kapazität des Koppelkondensators kann zum Beispiel in einem Bereich von etwa 100 pF bis etwa 1000 nF betragen. Dadurch kann erreicht werden, dass der Blindwiderstand steigt, sodass der Stromfluss sinkt. Im Fehlerfall kann bei Beaufschlagung mit Netzspannung erreicht werden, dass der Stromfluss so gering ist, dass das Geräteinnere sogar berührbar wäre, obwohl es an Netzspannung liegt. Der Koppelkondensator ist für eine Spannungsfestigkeit beziehungsweise eine Bemessungsspannung ausgelegt, die sich an der maximal möglichen Spannung orientiert, die bei der Anwendung auftreten kann. In der Gebäudetechnik ist dies in der Regel eine Wechselspannung von etwa 230 V bei etwa 50 Hz. Für den Koppelkondensator wird vorzugsweise vorgeschlagen, dass dieser eine Spezifikation X1 beziehungsweise Y2 aufweist, wie sie üblicherweise auch für Kondensatoren vorgesehen wird, die auch in Funkentstörfiltern zum Entstören von elektrischen Leitungen genutzt werden. Diese Spezifikationen unterliegen der Normung, weshalb von weiteren Ausführungen hierzu abgesehen wird. Der Koppelkondensator ist vorzugsweise als Keramikkondensator oder auch als Folienkondensator ausgebildet. Natürlich können auch Kombinationen hiervon vorgesehen sein. Der Koppelkondensator kann auch mehrere Kondensatorbauteile umfassen. Dem Grunde nach kann für jedes Anschlusselement ein jeweiliger Koppelkondensator vorgesehen sein.

Die Anschlusselemente können Anschlussleitungen umfassen, die vorzugsweise endseitig zum Anschließen an das elektromechanische Schaltelement Anschlussfahnen aufweisen können, die mit den entsprechenden Anschlusskontakten des elektromechanischen Schaltelements elektrisch und mechanisch verbunden werden können. Dem Grunde nach kann aber auch vorgesehen sein, dass die Anschlussleitungen unmittelbar mit den Anschlusskontakten elektrisch gekoppelt werden, beispielsweise mittels einer Verbindungstechnik wie Löten, Schweißen, Kleben, Klemmen und/oder dergleichen. Die Anschlusselemente können Leitungen umfassen, die lediglich einige wenige cm lang sind. Darüber hinaus können die Anschlusselemente jedoch auch Leitungen aufweisen, die bis zu etwa 100 m oder sogar noch mehr lang sind. Natürlich brauchen die wenigstens zwei Anschlusselemente nicht gleich lang zu sein und können je nach Aufbau und Konstruktion auch unterschiedliche Längen oder Anschlussmöglichkeiten bereitstellen.

Der Koppelkondensator weist einen ersten Kondensatoranschluss und einen zweiten Kondensatoranschluss auf. In der Regel können die Kondensatoranschlüsse mechanisch und/oder elektrisch im Wesentlichen gleich ausgebildet sein. Je nach Bedarf und Konstruktion können sie jedoch auch voneinander abweichen. Der erste Kondensatoranschluss ist mit einem ersten der Anschlusselemente elektrisch gekoppelt. Der zweite Kondensatoranschluss ist hingegen mit dem Spannungsgenerator zum Bereitstellen der zeitlich veränderlichen elektrischen Spannung elektrisch gekoppelt. Dadurch ist der Spannungsgenerator nicht unmittelbar mit dem ersten Anschlusselement verbunden, sodass der Spannungsgenerator bei einer fehlerhaften Beaufschlagung des ersten Anschlusselements mit einem unerwünscht hohen elektrischen Potential durch den Koppelkondensator, beispielsweise aufgrund einer strombegrenzenden Wirkung des Koppelkondensators wie zum Beispiel seines Blindwiderstands, geschützt werden kann.

Zugleich erlaubt es der Koppelkondensator, eine entsprechende elektrische Spannung aufgrund der zeitlich veränderlichen elektrischen Spannung des Spannungsgenerators auf das elektromechanische Schaltelement zu geben, sodass mit der Detektorschaltung der Schaltzustand des elektromechanischen Schaltelements ermittelt werden kann.

Der Spannungsgenerator kann eine elektronische Schaltung umfassen, die zum Beispiel als Hardwareschaltung auch in Kombination mit einer Rechnereinheit oder dergleichen ausgebildet sein kann. Der Spannungsgenerator stellt die zeitlich variable elektrische Spannung in vorgebbarer Weise bereit, zu welchem Zweck der Spannungsgenerator eine Einstelleinheit aufweisen kann. So kann zum Beispiel vorgesehen sein, eine Amplitude, eine Frequenz, eine Spannungsform und/oder dergleichen einstellen zu können. Dem Grunde nach können wenigstens einige dieser Parameter jedoch auch zumindest teilweise fest vorgegeben sein, beispielsweise durch eine entsprechende Gestaltung der Hardwareschaltung oder dergleichen.

Mit dem zweiten der Anschlusselemente ist die erste Überspannungsschutzschaltung elektrisch gekoppelt beziehungsweise an dieses angeschlossen. Die erste Überspannungsschutzschaltung umfasst vorzugsweise eine Hardwareschaltung, die ausgebildet ist, eine elektrische Spannung, deren Betrag größer als ein maximaler Betrag der zeitlich veränderlichen elektrischen Spannung des Spannungsgenerators ist, zu blockieren. Blockieren meint in diesem Zusammenhang nicht nur, dass eine elektrische Spannung unterbrochen werden kann, sondern insbesondere auch, dass die elektrische Spannung auf einen durch die erste Überspannungsschutzschaltung vorgegebenen Wert begrenzt sein kann. Zu diesem Zweck können entsprechende elektronische Bauteile vorgesehen sein, beispielsweise Suppressordioden, Zehnerdioden, Schutzwiderstände, Kombinationsschaltungen hiervon und/oder dergleichen. Vorzugsweise greift die erste Überspannungsschutzschaltung nur dann ein beziehungsweise wird nur dann aktiv, wenn eine Spannung vorliegt, die größer als eine maximal mögliche Spannung des Spannungsgenerators ist. Dadurch kann erreicht werden, dass die erste Überspannungsschutzschaltung im bestimmungsgemäßen Betrieb im Wesentlichen nicht aktiv ist und somit die Funktion der Sensoreinrichtung im Wesentlichen nicht beeinträchtigt, wenn der Sensoreinrichtung der Schaltzustand des elektromechanischen Schaltelements ermittelt wird. Hierfür kann vorgesehen sein, dass die erste Überspannungsschutzschaltung abhängig von Eigenschaften des Spannungsgenerators eingestellt wird.

Mit der ersten Überspannungsschutzschaltung ist ferner die Detektorschaltung elektrisch gekoppelt. Die Detektorschaltung ist ausgebildet, eine elektrische Spannung zu erfassen und durch Auswerten der erfassten elektrischen Spannung den Schaltzustand des elektromechanischen Schaltelements zu ermitteln. Zu diesem Zweck kann eine elektronische Schaltung, beispielsweise nach Art einer Hardwareschaltung und/oder eine Rechnereinheit vorgesehen sein, die insbesondere aus einem zeitlichen Verlauf der erfassten elektrischen Spannung den Schaltzustand zu ermitteln vermag. Dem Grunde nach kann jedoch auch lediglich eine statische Auswertung der erfassten elektrischen Spannung erfolgen, indem beispielsweise die erfasste elektrische Spannung mit einem Spannungsvergleichswert verglichen wird, wobei ein Wert der erfassten elektrischen Spannung, der größer als der Spannungsvergleichswert ist, den ausgeschalteten Schaltzustand repräsentiert, wohingegen ein kleinerer Wert der erfassten elektrischen Spannung als der Spannungsvergleichswert den eingeschalteten Schaltzustand repräsentiert. Dabei kann der Spannungsvergleichswert vorzugsweise derart definiert werden, dass auch Übergangswiderstände, die im eingeschalteten Schaltzustand des Schaltelements beispielsweise zwischen den Kontaktelementen auftreten können, berücksichtigt werden oder dergleichen. Das Erfassen der elektrischen Spannung kann das Erfassen einer Spannungsamplitude, einer Spannungsform, einer Frequenz und/oder dergleichen umfassen. Dadurch kann quasi eine 100% Immunität gegen Fehldetektion erreicht werden, weil in der Regel keine Fehler identische Signalformen sowie Taktfrequenzen aufweisen.

Die Detektorschaltung liefert vorzugsweise ein Signal, welches den ermittelten Schaltzustand des elektromechanischen Schaltelements repräsentiert. Ein solches Signal kann zum Beispiel ein analoges elektrisches Signal, beispielsweise eine elektrische Spannung, ein elektrischer Strom oder dergleichen sein. Darüber hinaus kann das Signal natürlich auch ein digitales Signal sein, beispielsweise ein binär codiertes Signal, welches den Schaltzustand repräsentiert.

Gemäß einer vorteilhaften Weiterbildung wird vorgeschlagen, dass der Spannungsgenerator ausgebildet ist, eine zeitliche Folge von Spannungsimpulsen oder eine Wechselspannung bereitzustellen. Die zeitliche Folge von Spannungsimpulsen kann zum Beispiel eine endliche Anzahl von Spannungsimpulsen umfassen. Natürlich kann auch vorgesehen sein, dass die Folge von Spannungsimpulsen zeitlich nicht begrenzt ist. Die Spannungsimpulse können im Wesentlichen gleich ausgebildet sein. Natürlich können die Spannungsimpulse auch abweichend voneinander ausgebildet sein, beispielsweise hinsichtlich ihrer Amplitude, ihrer Pulsbreite und/oder dergleichen. Die von Spannungsimpulse können ferner eine vorgebbare Flankensteilheit aufweisen, beispielsweise zu Beginn und/oder zum Ende eines jeweiligen der Spannungsimpulse. Die Spannungsimpulse sind vorzugsweise zumindest in einem zeitlichen Abstand von etwa 700 us, vorzugsweise etwa 150 us, besonders bevorzugt 100 us zueinander zeitlich beabstandet. Natürlich kann der zeitliche Abstand von zwei unmittelbar aufeinander folgenden Spannungsimpulsen auch kleiner gewählt sein. Eine Zeitdauer eines jeweiligen Spannungsimpulses kann zum Beispiel etwa 70 $\mu$s oder weniger betragen, vorzugsweise etwa 50 us, insbesondere etwa 25 us, besonders bevorzugt etwa 10 us. Die Zeitdauer der Impulse kann für alle Impulse gleich sein. Die Zeitdauer braucht jedoch nicht für alle Impulse gleich zu sein und kann je nach Bedarf variieren. Insbesondere kann vorgesehen sein, dass durch die Spannungsimpulse Impulsmuster wie zum Beispiel Bursts oder dergleichen gebildet werden.

Die Wechselspannung kann eine reine Wechselspannung oder auch eine Wechselspannung mit einem Gleichspannungsanteil sein. Die Wechselspannung kann sinusförmig, dreieckförmig, sägezahnförmig, rechteckförmig und/oder dergleichen sein. Vorzugsweise ist die Amplitude der Wechselspannung zeitlich konstant. Je nach Bedarf kann sie jedoch auch zeitlich variieren. Eine Frequenz der Wechselspannung ist vorzugsweise größer als etwa 1,5 kHz, vorzugsweise größer als etwa 5 kHz, besonders bevorzugt größer als etwa 10 kHz.

Ferner wird vorgeschlagen, dass der Spannungsgenerator ein Energiespeicherelement zum Speichern von elektrischer Energie sowie ein in einem Schaltbetrieb betreibbares Halbleiterschaltelement aufweist, wobei der Spannungsgenerator ausgebildet ist, durch den Betrieb des Halbleiterschaltelements im Schaltbetrieb das Energiespeicherelement abhängig von der durch den Spannungsgenerator bereitzustellenden zeitlich veränderlichen elektrischen Spannung mit dem Koppelkondensator elektrisch zu koppeln. Dadurch kann auf einfache Weise eine Spannungsimpulsfolge bereitgestellt werden, die die gewünschte Funktion der Sensoreinrichtung zu realisieren vermag. Das Halbleiterschaltelement kann zum Beispiel wenigstens einen im Schaltbetrieb betriebenen Transistor, insbesondere einen Feldeffekttransistor, vorzugsweise einen Metaloxide-Semiconductor-Field-Effect-Transistor (MOSFET), aber auch einen bipolaren Transistor, insbesondere einen Insulated-Gate-Bipolar-Transistor (IGBT) oder dergleichen aufweisen. Natürlich können auch Kombinationsschaltungen aus Transistoren, insbesondere unterschiedlichen Transistoren, beispielsweise auch in Verbindung mit weiteren elektronischen Bauteilen wie zum Beispiel elektrischen Widerständen, elektrischen Kondensatoren und/oder dergleichen vorgesehen sein. Darüber hinaus kann dem Grunde nach auch ein Thyristor als Halbleiterschaltelement vorgesehen sein, insbesondere ein Gate-Turn-Off-Thyristor (GTO) oder dergleichen.

In Bezug auf ein Halbleiterschaltelement unter Nutzung eines Transistors bedeutet der Schaltbetrieb, dass in einem eingeschalteten Schaltzustand zwischen den eine Schaltstrecke bildenden Anschlüssen des Transistors ein sehr kleiner elektrischer Widerstand bereitgestellt wird, sodass ein hoher Stromfluss bei sehr kleiner Restspannung beziehungsweise sehr kleinem Spannungsabfall möglich ist. In einem ausgeschalteten Schaltzustand ist hingegen die Schaltstrecke des Transistors hochohmig, das heißt, sie stellt einen hohen elektrischen Widerstand bereit, sodass auch bei hoher, an der Schaltstrecke anliegender elektrischer Spannung im Wesentlichen kein oder nur ein sehr geringer, insbesondere vernachlässigbarer, Stromfluss vorliegt. Hiervon unterscheidet sich ein Linearbetrieb bei Transistoren.

Gemäß einer Weiterbildung wird vorgeschlagen, dass zwischen dem zweiten Kondensatoranschluss und dem Spannungsgenerator eine zweite Überspannungsschutzschaltung angeschlossen ist, die ausgebildet ist, eine elektrische Spannung, deren Betrag größer als ein maximaler Betrag der zeitlich veränderlichen elektrischen Spannung des Spannungsgenerators ist, zu blockieren. Dem Grunde nach kann die zweite Überspannungsschutzschaltung ähnlich oder gleich wie die erste Überspannungsschutzschaltung ausgebildet sein. Jedoch kann durch die Schutzfunktion des Koppelkondensators erreicht werden, dass die zweite Überspannungsschutzschaltung gegenüber der ersten Überspannungsschutzschaltung vereinfacht ausgebildet sein kann, beispielsweise indem sie weniger Bauteile umfasst oder dergleichen. Beispielsweise kann die zweite Überspannungsschutzschaltung lediglich eine einzelne Zehnerdiode oder Suppressordiode umfassen oder dergleichen. Auf diese Weise kann die Schutzwirkung gegenüber dem Spannungsgenerator weiter verbessert werden, insbesondere wenn am ersten Anschlusselement eine besonders hohe elektrische Spannung mit einer hohen Spannungssteilheit anliegt. Ist nämlich die Spannungssteilheit sehr groß, kann die Schutzwirkung des Koppelkondensators begrenzt sein. Durch die zweite Überspannungsschutzschaltung kann die Schutzwirkung besonders in einem solchen Fall verbessert werden, sodass insgesamt die Schutzwirkung für den Spannungsgenerator weiter verbessert werden kann.

Besonders vorteilhaft erweist es sich, wenn zumindest der Spannungsgenerator und die Detektorschaltung an einen EIB-BUS angeschlossen sind. Dadurch kann erreicht werden, dass die Sensoreinrichtung für einen Feld-BUS, die dem EIB-BUS eingesetzt werden kann und auf diese Weise eine feldbusbasierte Gebäudeinstallation verbessert werden kann. Die Ausgestaltung ist jedoch nicht auf die Anwendung bei EIB-BUS beschränkt, sondern kann natürlich gleichermaßen auch bei dem KNX-BUS oder dergleichen eingesetzt werden. Durch diese Ausgestaltung ist es möglich, den Spannungsgenerator mit elektrischer Energie aus dem Feld-BUS zu versorgen und zugleich mittels der Detektorschaltung den ermittelten Schaltzustand des elektromechanischen Schaltelements über den Feld-BUS an eine Empfangsstelle entsprechend zu übermitteln. Zu diesem Zweck sind der Spannungsgenerator und die Detektorschaltung entsprechend ausgebildet. Der Spannungsgenerator kann zu diesem Zweck eine Spannungsversorgungsschaltung umfassen, die eine Energieversorgung des Spannungsgenerators mit Energie aus dem EIB-BUS ermöglicht. Die Detektorschaltung kann darüber hinaus eine Signalverarbeitung umfassen, die beispielsweise eine Rechnereinheit aufweisen kann, um in geeigneter Weise ein entsprechendes Signal, welches den ermittelten Schaltzustand repräsentiert, über den Feld-BUS abgeben zu können.

Eine vorteilhafte Weiterbildung schlägt vor, dass die Sensoreinrichtung zumindest eine Induktivität aufweist, die zwischen dem ersten Anschlusselement und dem Spannungsgenerator angeschlossen ist. Dadurch ist es möglich, zusätzliche Effekte in Bezug auf die Zuverlässigkeit der Erfassung des Schaltzustands des elektromechanischen Schaltelements zu verbessern. Durch die Induktivität kann zum Beispiel erreicht werden, dass bei Nutzung von Spannungsimpulsen sowie auch bei unstetigen Wechselspannungen wie zum Beispiel einer Rechteckspannung, ein Schwingvorgang ausgelöst wird, der die Zuverlässigkeit der Detektion zu verbessern vermag. Die Induktivität kann als elektronisches Bauteil ausgebildet sein. Natürlich kann die Induktivität auch durch mehrere elektronische Bauteile gebildet sein, die in geeigneter Weise in den Wirkungspfad eingeschleift sein können. Die Induktivität kann zum Beispiel auch zumindest teilweise durch eine oder mehrere externe Leitungen gebildet sein. Darüber hinaus kann die Induktivität auch intern als diskretes Bauteil, beispielsweise als Festinduktivität, als Luftspule, als Leiterplattenspule, Kombinationen hiervon oder dergleichen gebildet sein.

Es wird weiterhin vorgeschlagen, dass wenigstens der Spannungsgenerator und die Detektorschaltung ein gleiches elektrisches Bezugspotential nutzen. Dadurch kann eine besonders einfache und zuverlässige Sensoreinrichtung erreicht werden. Das Bezugspotential kann zum Beispiel ein Massepotential der Sensoreinrichtung sein.

Besonders vorteilhaft stellt der Spannungsgenerator eine Rechteckspannung bereit. Die Rechteckspannung eignet sich besonders für die erfindungsgemäße Sensoreinrichtung und die erfindungsgemäße Verfahrensführung. Sie kann auf einfache Weise durch den Spannungsgenerator erstellt werden und ist auf ebenso einfache und zuverlässige Weise mittels der Detektorschaltung aus der erfassten elektrischen Spannung ermittelbar.

Darüber hinaus wird vorgeschlagen, dass die zeitlich veränderliche elektrische Spannung derart gewählt wird, dass eine Verschmutzung wenigstens eines mit einem der Anschlusskontakte elektrisch verbundenen Kontaktelements zumindest teilweise entfernt wird. Zu diesem Zweck kann vorgesehen sein, dass eine besonders hohe Anzahl von Spannungsimpulsen mit einer vorzugsweise ebenfalls großen Spannungssteilheit bereitgestellt wird, sodass insgesamt ein vergleichsweise großer Stromfluss über die Kontaktelemente des elektromechanischen Schaltelements erreicht werden kann. Gleiches kann dem Grunde nach auch mit der Wechselspannung erreicht werden, die eine entsprechend hohe Frequenz aufweist. Dadurch ist es möglich, trotz des Koppelkondensators einen vergleichsweise großen Strom durch die Kontaktelemente zu erreichen, wenn diese sich im eingeschalteten Schaltzustand berühren, sodass etwaige Verschmutzungen, beispielsweise Rückstände, Korrosionen oder dergleichen entfernt werden können, indem sie zum Beispiel abbrennen oder dergleichen. Die Zuverlässigkeit der Funktion der Sensoreinrichtung kann dadurch weiter verbessert werden. Ein Spitzenstrom, der geeignet sein kann, beträgt beispielsweise etwa 0,4 A oder mehr, vorzugsweise etwa 0,5 A, besonders bevorzugt etwa 1,1 A.

Die für die erfindungsgemäße Sensoreinrichtung angegebenen Vorteile und Wirkungen gelten natürlich gleichermaßen auch für das erfindungsgemäße Verfahren und umgekehrt. Infolgedessen können natürlich auch Vorrichtungsmerkmale als Verfahrensmerkmale oder umgekehrt formuliert sein.

Weitere vorteilhafte Wirkungen und Merkmale sind der folgenden Beschreibung von Ausführungsbeispielen anhand von den beigefügten Figuren zu entnehmen. In den Figuren bezeichnen gleiche Bezugszeichen gleiche Merkmale und Funktionen.

Es zeigen:

FIG 1 eine schematische Blockschaltbilddarstellung einer an einem EIB-BUS angeschlossenen Sensoreinrichtung zum Ermitteln von Schaltzuständen von einer Mehrzahl von an die Sensoreinrichtung angeschlossenen manuell betätigbaren Schaltern;

FIG 2 eine schematische Blockschaltbilddarstellung der Sensoreinrichtung gemäß FIG 1;

FIG 3 eine schematische Blockschaltbilddarstellung wie FIG 2, wobei jedoch Details eines Spannungsgenerators und einer Detektorschaltung dargestellt sind;

FIG 4 eine schematische Schaltbilddarstellung für einen Spannungsgenerator gemäß FIG 3;

FIG 5 eine schematische Schaltbilddarstellung für eine erste Überspannungsschutzschaltung in Verbindung mit einer Detektorschaltung gemäß FIG 3,

FIG 6 eine schematische Diagrammdarstellung von Signalen erzeugt mit den Schaltungen gemäß der FIG 4 und 5; und

FIG 7 eine schematische Diagrammdarstellung von Signalen wie FIG 6, wobei zwischen dem Spannungsgenerator und dem ersten Anschlusselement eine Induktivität angeschlossen ist.

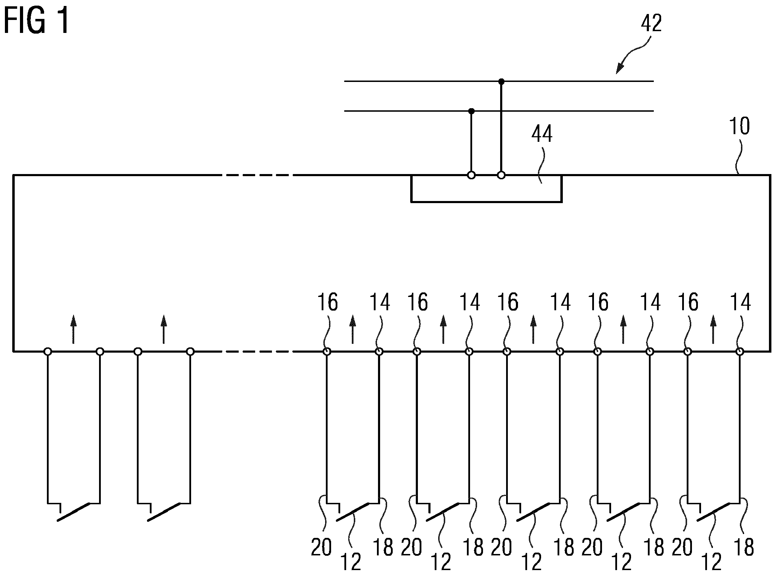

FIG 1 zeigt in einer schematischen Blockschaltbilddarstellung eine Sensoreinrichtung 10 zum Ermitteln von Schaltzuständen von an die Sensoreinrichtung 10 angeschlossenen manuell betätigbaren Schaltern 12 als elektromechanische Schaltelemente. Vorliegend sind exemplarisch fünf derartige manuelle Schalter 12 dargestellt. An die Sensoreinrichtung 10 können jedoch auch nahezu beliebig viele manuelle Schalter 12 angeschlossen sein. Die Sensoreinrichtung 10 ist dann entsprechend ausgebildet.

Jeder manuell betätigbarer Schalter 12 umfasst zwei Anschlusskontakte 18, 20, mittels denen der manuell betätigbare Schalter 12 an die Sensoreinrichtung 10 angeschlossen werden kann. Jeder der manuell betätigbaren Schalter 12 umfasst nicht dargestellte Kontaktelemente, die mit seinen jeweiligen Anschlusskontakten 18, 20 elektrisch verbunden sind. In einem eingeschalteten Schaltzustand sind diese Kontaktelemente miteinander mechanisch in Kontakt, sodass eine elektrische Verbindung zwischen den jeweiligen Anschlusskontakten 18, 20 des jeweiligen manuell betätigbaren Schalters 12 bereitgestellt wird. In einem ausgeschalteten Schaltzustand sind diese Kontaktelemente voneinander beabstandet zueinander positioniert, sodass eine elektrische Verbindung zwischen den Anschlusskontakten 18, 20 unterbrochen ist. Der manuell betätigbare Schalter 12 kann zum Beispiel als Drehschalter, als Kippschalter, als Tastschalter oder dergleichen ausgebildet sein. Dem Grunde nach ist die Erfindung jedoch nicht auf manuell betätigbare Schalter beschränkt. Es kann ebenso vorgesehen sein, dass der Schalter 12 mittels einer Antriebseinrichtung, beispielsweise eines pneumatischen Antriebs, eines elektrischen Antriebs, eines hydraulischen Antriebs oder dergleichen betätigt werden kann.

Die Sensoreinrichtung 10 umfasst eine BUS-Einheit 44, mittels der die Sensoreinrichtung 10 an einen EIB-BUS 42 angeschlossen werden kann. Dadurch eignet sich die Sensoreinrichtung 10 besonders für den Einsatz bei einer Gebäudeautomation.

Die Sensoreinrichtung 10 ermittelt den Schaltzustand eines jeweiligen der manuellen Schalter 12 und gibt ein digitales Signal abhängig vom ermittelten Schaltzustand über den EIB-BUS 42 ab. Zugleich dient der EIB-BUS 42 auch zur Energieversorgung der Sensoreinrichtung 10, wie im Folgenden noch erläutert werden wird.

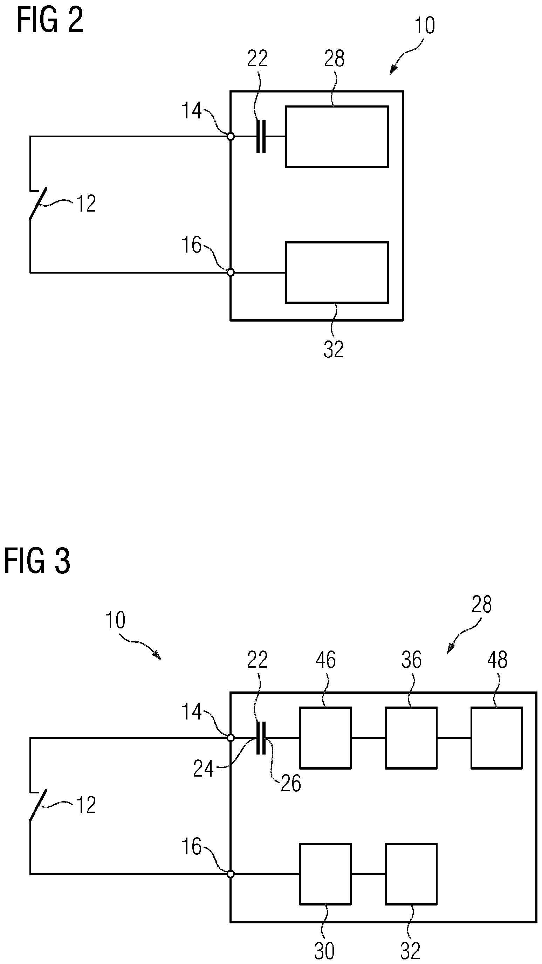

FIG 2 zeigt in einer schematischen Blockschaltbilddarstellung einen groben schematischen Aufbau der Sensoreinrichtung 10. Die Sensoreinrichtung 10 umfasst für einen jeweiligen manuell betätigbaren Schalter 12 genau zwei Anschlusselemente 14, 16, die zum elektrischen Kontaktieren der jeweiligen Anschlusskontakte 18, 20 des jeweiligen manuell betätigbaren Schalters 12 dienen.

An einem Anschlusselement 14 ist ein Spannungsgenerator 28 über einen Koppelkondensator 22 angeschlossen. Am Anschlusselement 16 ist hingegen eine Detektorschaltung 32 angeschlossen, die jedoch nicht unmittelbar am Anschlusselement 16 angeschlossen ist, wie im Folgenden noch genauer erläutert wird.

FIG 3 zeigt eine detailliertere Schaltbilddarstellung der Sensoreinrichtung 10 gemäß FIG 2. Der Spannungsgenerator 28 umfasst eine Spannungsversorgungseinheit 48, die aus dem EIB-BUS 42 - wie oben erläutert - elektrische Energie gewinnt und die Spannungsversorgung dem Spannungsgenerator 28 zur Verfügung stellt. Zu diesem Zweck ist für die Spannungsversorgungseinheit 48 ein Pufferkondensator 36 zum Speichern der bereitgestellten elektrischen Energie vorgesehen.

An den Pufferkondensator 36 ist ein Taktgenerator 46 angeschlossen, der in vorgebbarer Weise eine im Wesentlichen rechteckförmige Wechselspannung als zeitlich veränderliche elektrische Spannung bereitstellt. Diese Rechteckspannung wird auf einen zweiten Kondensatoranschluss 26 des Koppelkondensators 22 gegeben, der mit seinem ersten Kondensatoranschluss 24 mit dem ersten der Anschlusselemente 14 elektrisch gekoppelt ist. Dadurch steht am ersten Anschlusselement 14 eine entsprechende Wechselspannung zur Verfügung.

Die Kapazität des Koppelkondensators 22 ist derart gewählt, dass bei einem fälschlichen Anschluss des Kontaktelements 14 an beispielsweise einen Anschluss, der mit einer Wechselspannung von etwa 230 V bei etwa 50 Hz beaufschlagt ist, im Wesentlichen keine Beschädigung des Spannungsgenerators 28 auftritt. Der Kondensator 22 ist vorliegend als X1/Y2-Sicherheitskondensator ausgebildet und hat im vorliegenden eine Kapazität von Fall etwa 680 pF. Dies kann - je nach Anwendung - auch abweichend gewählt sein.

Am zweiten Anschlusselement 16 ist eine erste Überspannungsschutzschaltung 30 angeschlossen, die ausgebildet ist, eine elektrische Spannung am Anschlusselement 16 zu erfassen beziehungsweise abzugreifen und einen Betrag der erfassten elektrischen Spannung zu begrenzen. Vorliegend ist vorgesehen, dass die erfasste elektrische Spannung derart begrenzt wird, dass sie, wenn deren Betrag größer als ein maximaler Betrag der zeitlich veränderlichen elektrischen Spannung des Spannungsgenerators 28 ist, auf diesen Wert begrenzt wird. Blockieren meint hier daher insbesondere begrenzen. In alternativen Ausgestaltungen kann natürlich vorgesehen sein, dass die Überspannungsschutzschaltung 30 in einem Aktivierungsfall keine Spannung durchlässt.

An die erste Überspannungsschutzschaltung 30 ist ferner eine Detektorschaltung 32 angeschlossen, die ausgebildet ist, die erfasste elektrische Spannung auszuwerten und dadurch den Schaltzustand des jeweiligen manuellen Schalters 12 zu ermitteln. Zu diesem Zweck umfasst die Detektorschaltung 32 eine nicht dargestellte Rechnereinheit. Die Detektorschaltung 32 umfasst vorliegend auch die BUS-Einheit 44, sodass die Detektorschaltung 32 ein einem ermittelten Schaltzustand entsprechendes Signal an den EIB-BUS 42 abgeben kann.

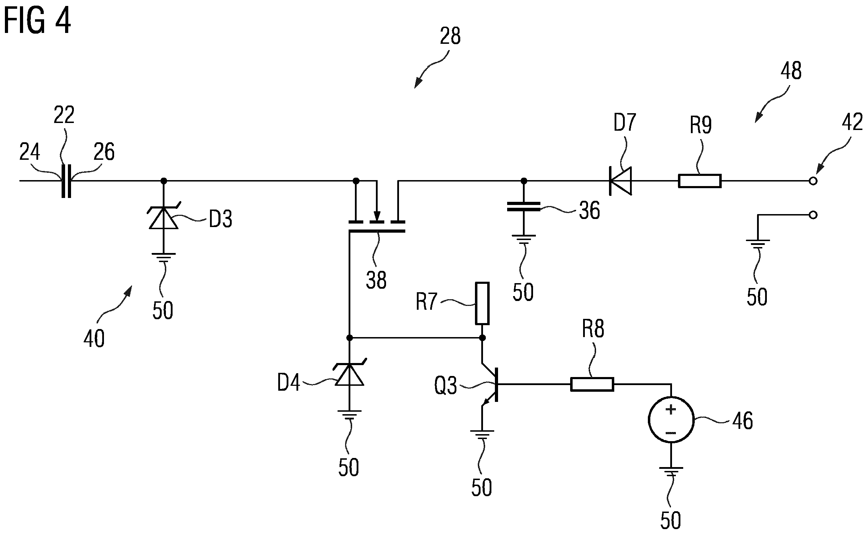

FIG 4 zeigt in einer schematischen Schaltbilddarstellung einen möglichen Aufbau des Spannungsgenerators 28 in Verbindung mit dem Koppelkondensator 22. Zu erkennen ist, dass der Koppelkondensator 22 mit seinem zweiten Kondensatoranschluss 26 mit einer Zehnerdiode D3 elektrisch gekoppelt ist, die ihrerseits mit ihrem gegenüberliegenden Anschluss an ein Massepotential 50 der Sensoreinrichtung 10 angeschlossen ist. Durch die Zehnerdiode D3 wird eine zweite Überspannungsschutzschaltung 40 gebildet.

Der zweite Kondensatoranschluss 26 ist ferner an einen nicht gezeigten Source-Anschluss eines MOSFET 38 als Halbleiterschaltelement angeschlossen, dessen Drain an den Pufferkondensator 36 angeschlossen ist, der mit seinem gegenüberliegenden Anschluss ebenfalls an das Massepotential 50 angeschlossen ist. An einen Gate-Anschluss des MOSFET 38 ist eine Zehnerdiode D4 angeschlossen, die mit ihrem gegenüberliegenden Anschluss ebenfalls an das Massepotential 50 angeschlossen ist und somit den Gate-Anschluss des MOSFET 38 vor eine Überspannung schützt.

Der Taktgenerator 46 stellt vorliegend eine Rechteckspannung mit einer Frequenz von etwa 10 kHz bereit. Die Rechteckspannung wird über einen Widerstand R8 einer Basis eines in Emitterschaltung betriebenen bipolaren NPN-Transistors zugeführt, der dieses Signal für eine Beaufschlagung des Gate-Anschlusses des MOSFET 38 in geeigneter Weise verstärkt. Auf die Details der Emitterschaltung braucht nicht eingegangen zu werden, weil sie dem Fachmann hinlänglich bekannt ist.

Durch den durch die Rechteckspannung hervorgerufenen Schaltbetrieb des MOSFET 38, der auf die vorgeschriebene Weise erreicht wird, wird ferner in der Folge am ersten Anschlusselement 14 eine entsprechende Wechselspannung bereitgestellt.

Der Taktgenerator 46 ist ferner an eine Spannungsversorgungseinheit 48 angeschlossen, die ausgebildet ist, aus dem EIB-BUS 42 elektrische Energie für den Betrieb des Taktgenerators 46 bereitzustellen. Zu diesem Zweck ist der EIB-BUS 42 über einen Widerstand R9 und eine Diode D7 an den Pufferkondensator 36 angeschlossen. Dadurch kann aus der Betriebsspannung des EIB-BUSSES 42 eine Gleichspannung am Pufferkondensator 36 bereitgestellt werden, die vorliegend etwa 30 V beträgt. Diese Spannung dient zur Energieversorgung des Spannungsgenerators 28, das heißt, auch für den MOSFET 38. In alternativen Ausgestaltungen kann dies natürlich auch variieren. Diese Gleichspannung dient vorliegend zur Energieversorgung sämtlicher Komponenten des Spannungsgenerators 28.

Am zweiten Anschlusselement 16 ist zunächst ein Kondensator C8 angeschlossen, dessen gegenüberliegender Anschluss an das Massepotential 50 angeschlossen ist. Dadurch kann eine integrative Wirkung in Bezug auf die erfasste Spannung am zweiten Anschlusselement 16 erreicht werden. Der Kondensator C8 hat vorliegend eine Kapazität von etwa 100 nF.

An den Kondensator C8 ist ferner eine erste Überspannungsschutzschaltung 30 angeschlossen, die ausgebildet ist, eine elektrische Spannung, deren Betrag größer als ein maximaler Betrag der vom Spannungsgenerator 28 bereitgestellten elektrischen Spannung ist, zu blockieren beziehungsweise zu begrenzen. Zu diesem Zweck ist vorliegend vorgesehen, dass an den Kondensator C8 zunächst eine Zehnerdiode D6 und dann eine Reihenschaltung aus einem elektrischen Widerstand R4 und einer zweiten Zehnerdiode D1 angeschlossen ist. Dieses Netzwerk ermöglicht eine zuverlässige Spannungsbegrenzung.

An einem Mittelabgriff der Reihenschaltung aus dem elektrischen Widerstand R4 und der Zehnerdiode D1 ist über einen weiteren elektrischen Widerstand R3 die Detektorschaltung 32 angeschlossen, die vorliegend durch einen Mikroprozessor als Rechnereinheit gebildet ist. Der Mikroprozessor ist vorliegend ebenfalls an den EIB-BUS 42 angeschlossen, was jedoch in den FIG. nicht dargestellt ist. Der Mikroprozessor stellt also vorliegend zugleich auch die Funktionalität der BUS-Einheit 44 bereit. Dadurch kann die erste elektrische Spannung am zweiten Anschlusselement 16 durch den Mikroprozessor ausgewertet werden, sodass der Schaltzustand des manuell betätigbaren Schalters 12 ermittelt werden kann. Nicht dargestellt ist, dass der Mikroprozessor abhängig vom ermittelten Schaltzustand des manuell betätigbaren Schalters 12 ein entsprechendes digitales Signal angepasst an den EIB-BUS 42 abgibt.

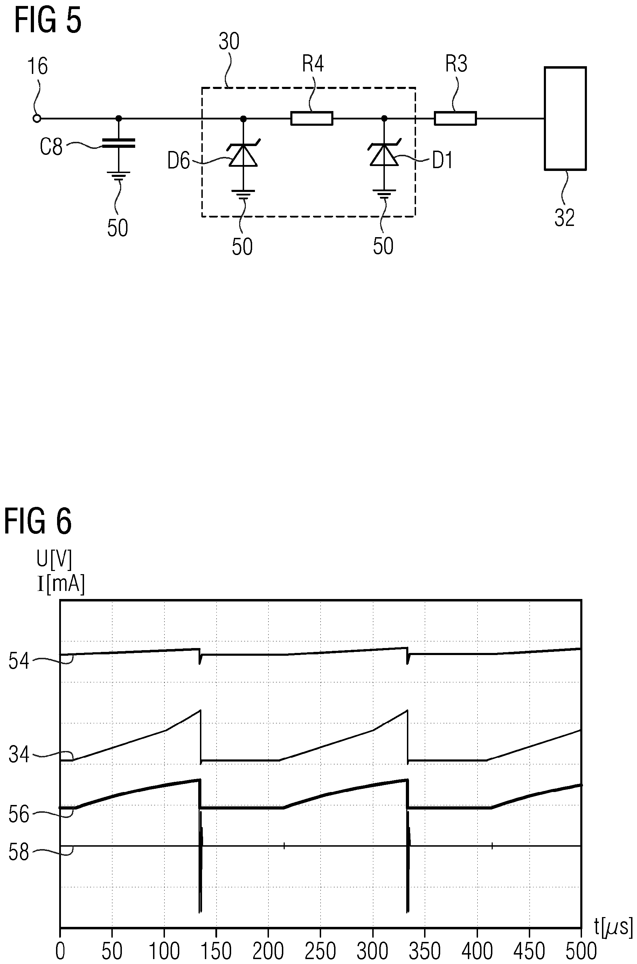

FIG 6 zeigt in einer schematischen Diagrammdarstellung die Funktion der Sensoreinrichtung 10. Die Abszisse ist der Zeit zugeordnet, wohingegen die Ordinate abhängig vom jeweils betrachteten dargestellten Graph entweder einer elektrischen Spannung oder einem elektrischen Strom zugeordnet ist.

Mit einem Graphen 54 ist im Diagramm gemäß FIG 6 eine elektrische Spannung am Kondensator vor dem MOSFET 38 dargestellt. Aus dem Diagramm ist ersichtlich, dass die elektrische Spannung vorliegend etwa 30 V beträgt. Mit einem Graphen 34 ist ein Ansteuersignal am Gate-Anschluss für den MOSFET 38 dargestellt. Hieraus ist ersichtlich, dass das Ansteuersignal nicht vollständig rechteckförmig ist, sondern aufgrund von Eigenschaften der Schaltung verzerrt ist. Das Rechtecksignal weist hier somit eine Rampe auf. Dies ist jedoch für die Funktion der Schaltung insgesamt nicht hinderlich.

Mit einem Graphen 56 ist ein entsprechendes Spannungssignal dargestellt, welches der Detektorschaltung 32 zugeführt wird. Aus FIG 6 ist ersichtlich, dass der Graph 56 hinsichtlich eines Signalverlaufs etwa dem Graphen 34 entspricht.

Mit einem Graphen 58 ist ein Stromfluss dargestellt, wie er mit dem Spannungsgenerator 28 im eingeschalteten Schaltzustand des manuell betätigbaren Schalters 12 durch die Detektorschaltung 32 erfasst werden kann. Zu erkennen ist, dass Stromimpulse zu Zeitpunkten auftreten, bei denen die Graphen 34, 56 große Flankensteilheiten aufweisen. Dies kann durch die Detektorschaltung 32 ausgewertet werden, sodass aus diesem Signal der Schaltzustand des manuellen Schalters 12 ermittelt werden kann.

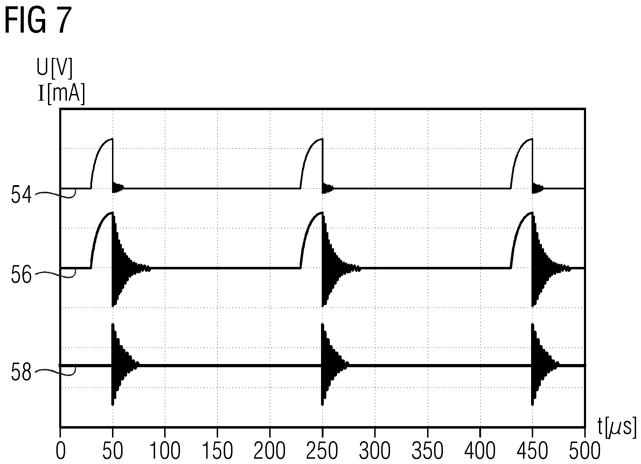

FIG 7 zeigt in einer weiteren schematischen Diagrammdarstellung wie FIG 6 die Verhältnisse, wenn der Spannungsgenerator 28 nicht nur über den Koppelkondensator 22 an das erste Anschlusselement 14 angeschlossen ist, sondern ergänzend auch noch eine weitere Induktivität in Reihe geschaltet ist. Zu erkennen ist, dass bezüglich der Graphen 56 und 58 ein vergrößerter Schwingvorgang erzeugt wird, der die Detektion durch die Detektorschaltung 32 verbessert. Die Zuverlässigkeit der Detektorschaltung kann damit erhöht werden.

In dem gemäß der FIG. dargestellten Ausführungsbeispielen wird die Kontaktstelle des manuell betätigbaren Schalters 12 mit einem elektrischen Spitzenstrom von etwa 200 mA beaufschlagt, wobei der Pufferkondensator 36 jedoch nur mit 0,75 mA geladen wird, das bedeutet, eine Ladeleistung von weniger als etwa 20 mW.

In der vorliegenden Ausgestaltung kommt der vergleichsweise große Stromfluss bereits bei einer Frequenz von etwa 5 kHz aufgrund des schnellen Abschaltens des MOSFET 38 zustande. Da die Frequenz des Spannungsgenerators 28 jedoch deutlich größer ist, reduziert sich der Blindwiderstand insbesondere des Koppelkondensators 22. Die folgende Beispielrechnung soll dies verdeutlichen:

$$I(50Hz) = \frac{230V}{\dfrac{1}{2\pi \cdot 50Hz \cdot 47nF}} = 3,396mA$$

Aus der vorgenannten Formel ist ersichtlich, dass bei Netzfrequenz ein vergleichsweise kleiner Stromfluss über den Koppelkondensator 22 erreicht wird. Dadurch kann der Spannungsgenerator 28 vor einer Beschädigung aufgrund einer Netzspannung geschützt werden. Dagegen erweist sich die Funktion zum Ermitteln des Schaltzustands durch die Erfindung als besonders vorteilhaft, weil sie, wie in der folgenden Formel dargestellt, einen vergleichsweise großen Stromfluss über die Kontaktelemente des manuell betätigbaren Schalters 12 ermöglicht.

Die folgende Formel verdeutlicht dies:

$$I(10kHz) = \frac{30V}{\dfrac{1}{2\pi \cdot 10kHz \cdot 47nF}} = 88mA$$

Es ist ersichtlich, dass bei der Betriebsfrequenz des Spannungsgenerators 28 bei etwa 10 kHz ein vergleichsweiser großer Strom in den manuell betätigbaren Schalter 12 eingespeist werden kann, vorliegend nämlich etwa 88 mA, und zwar obwohl der Spannungsgenerator 28 eine erheblich kleinere Spannung nutzt als die Netzspannung. Bei geeigneter Auslegung der Schaltung kann also auch sogar ein Freibrennen von Kontaktflächen des betätigbaren Schalters 12 erreicht werden.

Mit der Erfindung ist es also möglich, bei sehr guten Detektionseigenschaften der Detektorschaltung 32 zugleich eine Schutzwirkung für die Sensoreinrichtung 10 vor Überspannungen bereitzustellen, sodass insbesondere bei der Gebäudeautomation auftretende Montagefehler nicht zu einer Beschädigung beziehungsweise Zerstörung der Sensoreinrichtung 10 zu führen brauchen.

Die Ausführungsbeispiele dienen ausschließlich der Erläuterung der Erfindung und sollen diese nicht beschränken.

Bezugszeichenliste

| | |
|---|---|
| 10 | Sensoreinrichtung |
| 12 | manueller Schalter |
| 14 | erstes Anschlusselement |
| 16 | zweites Anschlusselement |
| 18 | Anschlusskontakt |
| 20 | Anschlusskontakt |
| 22 | Koppelkondensator |
| 24 | erster Kondensatoranschluss |
| 26 | zweiter Kondensatoranschluss |
| 28 | Spannungsgenerator |
| 30 | erste Überspannungsschutzschaltung |
| 32 | Detektorschaltung |
| 34 | Wechselspannung |
| 36 | Pufferkondensator |
| 38 | MOSFET |
| 40 | zweite Überspannungsschutzschaltung |
| 42 | EIB-BUS |
| 44 | BUS-Einheit |
| 46 | Taktgenerator |
| 48 | Spannungsversorgungseinheit |
| 50 | Massepotential |
| 54 | elektrische Spannung |
| 56 | Graph |
| 58 | Graph |
| C8 | Kondensator |
| D1 | Zehnerdiode |
| D3 | Zehnerdiode |
| D4 | Zehnerdiode |
| D6 | Zehnerdiode |
| D7 | Diode |
| Q3 | Transistor |
| R3 | Widerstand |
| R4 | Widerstand |
| R7 | Widerstand |
| R8 | Widerstand |
| R9 | Widerstand |

**Patentansprüche**

1.  Sensoreinrichtung (10) zum Ermitteln eines Schaltzustands eines elektromechanischen Schaltelements (12), mit:

    - wenigstens zwei Anschlusselementen (14, 16) zum elektrischen Kontaktieren von zwei jeweiligen Anschlusskontakten (18, 20) des elektromechanischen Schaltelements (12),
    - wenigstens einen Koppelkondensator (22) mit einem ersten und einem zweiten Kondensatoranschluss (24, 26), wobei der erste Kondensatoranschluss (24) mit einem ersten der Anschlusselemente (14) elektrisch gekoppelt ist,
    - einen Spannungsgenerator (28) zum Bereitstellen einer zeitlich veränderlichen elektrischen Spannung, wobei der Spannungsgenerator (28) mit dem zweiten Kondensatoranschluss (26) elektrisch gekoppelt ist, **gekennzeichnet durch**
    - eine mit einem zweiten der Anschlusselemente (16) elektrisch gekoppelte erste Überspannungsschutzschaltung (30), die ausgebildet ist, eine elektrische Spannung, deren Betrag größer als ein maximaler Betrag der zeitlich veränderlichen elektrischen Spannung des Spannungsgenerators (28) ist, zu blockieren, sowie
    - eine mit der ersten Überspannungsschutzschaltung (30) elektrisch gekoppelte Detektorschaltung (32), die ausgebildet ist, die elektrische Spannung zu erfassen und durch Auswerten der erfassten elektrischen Spannung den Schaltzustand des elektromechanischen Schaltelements (12) zu ermitteln.

2.  Sensoreinrichtung nach Anspruch 1, **dadurch gekennzeichnet, dass** der Spannungsgenerator (28) ausgebildet ist, eine zeitliche Folge Spannungsimpulsen oder eine Wechselspannung (34) bereitzustellen.

3.  Sensoreinrichtung nach einem der vorhergehenden Ansprüche, **dadurch gekennzeichnet, dass** der Spannungsgenerator (28) ein Energiespeicherelement (36) zum Speichern von elektrischer Energie sowie ein in einem Schaltbetrieb betreibbares Halbleiterschaltelement (38) aufweist, wobei der Spannungsgenerator (28) ausgebildet ist, durch den Betrieb des Halbleiterschaltelements (38) im Schaltbetrieb das Energiespeicherelement (36) abhängig von der durch den Spannungsgenerator (28) bereitzustellenden zeitlich veränderlichen elektrischen Spannung mit dem Koppelkondensator (22) elektrisch zu koppeln.

4.  Sensoreinrichtung nach einem der vorhergehenden Ansprüche, **dadurch gekennzeichnet, dass** zwischen dem zweiten Kondensatoranschluss (26) und dem Spannungsgenerator (28) eine zweite Überspannungsschutzschaltung (40) angeschlossen ist, die ausgebildet ist, eine elektrische Spannung, deren Betrag größer als ein maximaler Betrag der zeitlich veränderlichen elektrischen Spannung des Spannungsgenerators (28) ist, zu blockieren.

**5.** Sensoreinrichtung nach einem der vorhergehenden Ansprüche, **dadurch gekennzeichnet, dass** zumindest der Spannungsgenerator (28) und die Detektorschaltung (32) an einen EIB-BUS (42) angeschlossen sind.

**6.** Sensoreinrichtung nach einem der vorhergehenden Ansprüche, **gekennzeichnet durch** zumindest eine Induktivität, die zwischen dem ersten Anschlusselement (14) und dem Spannungsgenerator (28) angeschlossen ist.

**7.** Verfahren zum Ermitteln eines Schaltzustands eines elektromechanischen Schaltelements (12), mit den Schritten:

- Bereitstellen einer zeitlich veränderlichen elektrischen Spannung mittels eines Spannungsgenerators (28),
- Beaufschlagen eines ersten Anschlusskontaktes (18) des elektromechanischen Schaltelements (12) mit der zeitlich veränderlichen elektrischen Spannung über wenigstens einen Koppelkondensator (22),
- Erfassen einer elektrischen Spannung eines zweiten Anschlusskontaktes (20) des elektromechanischen Schaltelements (12) mittels einer Detektorschaltung (32) über eine erste Überspannungsschutzschaltung (30), die ausgebildet ist, eine elektrische Spannung, deren Betrag größer als ein maximaler Betrag der zeitlich veränderlichen elektrischen Spannung des Spannungsgenerators (28) ist, zu blockieren, und
- Ermitteln des Schaltzustands des elektromechanischen Schaltelements (12) mittels der Detektorschaltung (32) durch Auswerten der erfassten elektrischen Spannung.

**8.** Verfahren nach Anspruch 7, **dadurch gekennzeichnet, dass** wenigstens der Spannungsgenerator (28) und die Detektorschaltung (32) ein gleiches elektrisches Bezugspotential nutzen.

**9.** Verfahren nach Anspruch 7 oder 8, **dadurch gekennzeichnet, dass** der Spannungsgenerator (28) eine Rechteckspannung bereitstellt.

**10.** Verfahren nach einem der Ansprüche 7 bis 9, **dadurch gekennzeichnet, dass** die zeitlich veränderliche elektrische Spannung derart gewählt wird, dass eine Verschmutzung wenigstens eines mit einem der Anschlusskontakte (18, 20) elektrisch verbundenen Kontaktelements zumindest teilweise entfernt wird.

**Claims**

**1.** Sensor facility (10) for determining a switching state of an electromechanical switching element (12), having:

- at least two connection elements (14, 16) for electrically contacting two respective connection contacts (18, 20) of the electromechanical switching element (12),
- at least one coupling capacitor (22) having a first and a second capacitor connection (24, 26), wherein the first capacitor connection (24) is electrically coupled to a first one of the connection elements (14),
- a voltage generator (28) so as to provide a temporally variable electrical voltage, wherein the voltage generator (28) is electrically coupled to the second capacitor connection (26), **characterised by**
- a first overvoltage protection circuit (30) that is electrically coupled to a second one of the connection elements (16) and said overvoltage protection circuit (30) is designed so as to block an electrical voltage that has a value that is greater than a maximum value of the temporally variable electrical voltage of the voltage generator (28), and
- a detector circuit (32) that is electrically coupled to the first overvoltage protection circuit (30) and said detector circuit (32) is designed so as to detect electrical voltage and to determine the switching state of the electromechanical switching element (12) by evaluating the detected electrical voltage.

**2.** Sensor facility according to claim 1, **characterised in that** the voltage generator (28) is designed so as to provide a temporal sequence of voltage pulses or an alternating current voltage (34).

**3.** Sensor facility according to one of the preceding claims, **characterised in that** the voltage generator (28) has an energy storage device element (36) for storing electrical energy and a semiconductor switching element (38) that can be operated in a switching operation, wherein the voltage generator (28) is designed so as to electrically couple the energy storage device element (36) to the coupling capacitor (22) in dependence upon the temporally variable electrical voltage that is provided by the voltage generator (28) by the operation of the semiconductor switching element (38) in the switching operation.

**4.** Sensor facility according to one of the preceding claims, **characterised in that** a second overvoltage protection circuit (40) is connected between the second capacitor connection (26) and the voltage generator (28) and said second overvoltage protection circuit (40) is designed so as to block an electrical voltage that has a value that is greater than a maximum value of the temporally variable electrical voltage of the voltage generator (28).

5. Sensor facility according to one of the preceding claims, **characterised in that** at least the voltage generator (28) and the detector circuit (32) are connected to an EIB bus (42).

6. Sensor facility according to one of the preceding claims, **characterised by** at least one inductance that is connected between the first connection element (14) and the voltage generator (28).

7. Method for determining a switching state of an electromechanical switching element (12) having the steps:

   - providing a temporally variable electrical voltage by means of a voltage generator (28),
   - influencing a first connection contact (18) of the electromechanical switching element (12) with the temporally variable electrical voltage via at least one coupling capacitor (22),
   - detecting an electrical voltage of a second connection contact (20) of the electromechanical switching element (12) by means of a detector circuit (32) via a first overvoltage protection circuit (30) that is designed so as to block an electrical voltage that has a value that is greater than a maximum value of the temporally variable electrical voltage of the voltage generator (28), and
   - determining the switching state of the electromechanical switching element (12) by means of the detector circuit (32) by evaluating the detected electrical voltage.

8. Method according to claim 7, **characterised in that** at least the voltage generator (28) and the detector circuit (32) use a uniform electrical reference potential.

9. Method according to claim 7 or 8, **characterised in that** the voltage generator (28) provides a square wave voltage.

10. Method according to one of claims 7 to 9, **characterised in that** the temporally variable electrical voltage is selected in such a manner that a contamination of at least one contact element that is electrically connected to one of the connection contacts (18, 20) is at least in part removed.

**Revendications**

1. Dispositif de détection (10) pour déterminer un état de commutation d'un élément de commutation électromécanique (12), comprenant :

   - au moins deux éléments de connexion (14, 16) pour le contact électrique de deux contacts de connexion (18, 20) de l'élément de commutation électromécanique (12),
   - au moins un condensateur de couplage (22) avec une première et une seconde borne de condensateur (24, 26), dans lequel la première borne de condensateur (24) est couplée électriquement à un premier des éléments de connexion (14),
   - un générateur de tension (28) pour fournir une tension électrique variable dans le temps, dans lequel le générateur de tension (28) est couplé électriquement à la seconde borne de condensateur (26), **caractérisé par**
   - un premier circuit de protection contre les surtensions (30) couplé électriquement à un second des éléments de connexion (16), qui est conçu pour bloquer une tension électrique dont l'amplitude est supérieure à une amplitude maximale de la tension électrique variable dans le temps du générateur de tension (28), et
   - un circuit de détection (32) couplé électriquement au premier circuit de protection contre les surtensions (30), qui est conçu pour détecter la tension électrique et déterminer l'état de commutation de l'élément de commutation électromécanique (12) en évaluant la tension électrique détectée.

2. Dispositif de détection selon la revendication 1, **caractérisé en ce que** le générateur de tension (28) est conçu pour fournir une séquence temporelle d'impulsions de tension ou une tension alternative (34).

3. Dispositif de détection selon l'une des revendications précédentes, **caractérisé en ce que** le générateur de tension (28) comprend un élément de stockage d'énergie électrique (36) pour le stockage de l'énergie électrique, ainsi qu'un élément de commutation à semi-conducteur (38) pouvant fonctionner en mode de commutation, dans lequel le générateur de tension (28) est conçu pour coupler électriquement l'élément de stockage d'énergie électrique (36) avec le condensateur de couplage (22) en mode de commutation du fait du fonctionnement de l'élément de commutation à semi-conducteur (38) en fonction de la tension électrique variable dans le temps à fournir par le générateur de tension (28).

4. Dispositif de détection selon l'une des revendications précédentes, **caractérisé en ce qu'**un second circuit de protection contre les surtensions (40) est connecté entre la seconde borne de condensateur (26) et le générateur de tension (28), le second circuit de protection contre les surtensions est conçu pour bloquer une tension électrique dont la valeur est supérieure à une valeur maximale de la tension électrique variable dans le temps du générateur de tension (28).

5. Dispositif de détection selon l'une des revendications précédentes, **caractérisé en ce qu'**au moins le générateur de tension (28) et le circuit de détection (32) sont connectés à un BUS EIB (42).

6. Dispositif de détection selon l'une des revendications précédentes, **caractérisé en ce qu'**au moins une inductance est connectée entre le premier élément de connexion (14) et le générateur de tension (28).

7. Procédé pour déterminer un état de commutation d'un élément de commutation électromécanique (12), comprenant les étapes suivantes :

   - fournir une tension électrique variable dans le temps au moyen d'un générateur de tension (28),
   - appliquer à un premier contact de connexion (18) de l'élément de commutation électromécanique (12) la tension électrique variable dans le temps via au moins un condensateur de couplage (22),
   - détecter une tension électrique d'un second contact de connexion (20) de l'élément de commutation électromécanique (12) au moyen d'un circuit de détection (32) via un premier circuit de protection contre les surtensions (30), qui est conçu pour bloquer une tension électrique dont la valeur est supérieure à une valeur maximale de la tension électrique variable dans le temps du générateur de tension (28), et
   - déterminer l'état de commutation de l'élément de commutation électromécanique (12) au moyen du circuit de détection (32) en évaluant la tension électrique détectée.

8. Procédé selon la revendication 7, **caractérisé en ce qu'**au moins le générateur de tension (28) et le circuit de détection (32) utilisent un même potentiel électrique de référence.

9. Procédé selon la revendication 7 ou 8, **caractérisé en ce que** le générateur de tension (28) fournit une tension rectangulaire.

10. Procédé selon l'une des revendications 7 à 9, **caractérisé en ce que** la tension électrique variable dans le temps est sélectionnée de telle sorte qu'un encrassement d'au moins un élément de contact connecté électriquement à l'un des contacts de connexion (18, 20) est au moins partiellement éliminé.

FIG 1

FIG 2

FIG 3

FIG 4

EP 4 070 353 B1

FIG 5

FIG 6

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10146753 C1